# EUROPÄISCHE PATENTSCHRIFT

(11) **EP 4 246 262 B1**
(45) Veröffentlichungstag und Bekanntmachung des Hinweises auf die Patenterteilung: **10.09.2025**
(21) Anmeldenummer: 22163000.7
(22) Anmeldetag: 18.03.2022
(51) Int. Cl.: G05B 23/02, G05B 13/02, G06F 30/27

(54) **VERFAHREN UND VORRICHTUNG ZUR ÜBERWACHUNG EINES ZUSTANDS EINER KOMPONENTE EINER VERFAHRENSTECHNISCHEN ANLAGE**
METHOD AND DEVICE FOR MONITORING A STATE OF A COMPONENT OF A PROCESS ENGINEERING PLANT
PROCÉDÉ ET DISPOSITIF DE SURVEILLANCE DE L'ÉTAT D'UN COMPOSANT D'UNE INSTALLATION TECHNIQUE

(43) Veröffentlichungstag der Anmeldung: 20.09.2023
(73) Patentinhaber: Siemens Aktiengesellschaft, 80333 München (DE)
(72) Erfinder: Grießinger, Konrad Moritz, 76135 Karlsruhe (DE)
(74) Vertreter: Siemens Patent Attorneys

(56) Entgegenhaltungen:
- WO-A1-2020/198249
- WO-A1-2022/035427
- US-A1- 2022 075 515

## Beschreibung

Die Erfindung betrifft ein Verfahren zur Überwachung eines Zustands einer Komponente einer verfahrenstechnischen Anlage gemäß dem Oberbegriff des Patentanspruchs 1 sowie eine entsprechende Vorrichtung. Des Weiteren betrifft die Erfindung ein entsprechendes Computerprogramm und Computerprogrammprodukt.

Der Begriff der Zustandsüberwachung (engl. Condition Monitoring) bedeutet, dass der technische Zustand einer Maschine oder eines Maschinenteils regelmäßig oder permanent mithilfe von Sensoren erfasst wird und die anfallenden Sensordaten zur weiteren Verwendung analysiert werden. Aussagekräftige Messwerte der Sensoren sind zumeist physikalische Größen wie Temperatur, Druck, Schwingungen, Feuchtigkeit, Füllstände, usw.

Zustandsüberwachung kommt insbesondere für verfahrenstechnische Komponenten komplexer verfahrenstechnischer Anlagen der Prozessindustrie zum Einsatz. Der Begriff einer (verfahrenstechnischen) Komponente umfasst in diesem Zusammenhang verschiedene Maschinen oder Aggregate der Anlage, wie z. B. Behälter, Pumpen, Ventile, Wärmetauscher und ihre Verbindung miteinander, insbesondere Rohrleitungen. Alle Komponenten dienen dazu, bestimmte Medien wie Flüssigkeiten, Gase oder Feststoffe, zu fördern, trennen, zu temperieren, reagieren zu lassen oder auf sonstige Weise hinsichtlich Zusammensetzung, Art oder Eigenschaften zu verändern. Die Sensorik innerhalb einer verfahrenstechnischen Anlage ist dazu ausgebildet, Prozessvariablen, wie Temperatur, Druck, Füllstände etc. zu erfassen.

Die einfachste Art der Zustandsüberwachung besteht darin, jeden Sensormesswert, der mit einem Gerät in Verbindung steht, zu betrachten und hinsichtlich Anomalien zu analysieren, d.h. zu überprüfen, ob der aktuelle Wert innerhalb vorgegebener Grenzwerte liegt, was bedeutet, dass die Maschine in Ordnung ist. Liegt der aktuelle Wert außerhalb der Grenzwerte, ist das Gerät nicht in Ordnung und es wird ein Alarm gesendet.

Zur Erkennung von Anomalien in Sensordaten werden häufig auf maschinellem Lernen basierende Methode verwendet. Beim so genannten "Maschinellen Lernen" (engl. Machine Learning, abgekürzt ML) lernt ein künstliches, computerimplementiertes System Muster und Zusammenhänge aus Daten. Auf diese Weise können nach Beendigung der Lernphase aus Beispielen, welchen auf historischen Daten basieren, Zusammenhänge verallgemeinert, Ausreißer und unbekannte Muster erkannt werden. Dazu bauen Algorithmen ein statistisches Modell auf, das auf Trainings- oder Lerndaten beruht. Wenn ein Machine Learning Algorithmus (ML Algorithmus) trainiert werden soll, um z.B. das Verhalten einer verfahrenstechnischen Komponente in einer Industrieanlage zu überwachen oder vorherzusagen, muss dem Algorithmus zuvor ein Trainingsdatensatz zugeführt werden.

Bei großen und komplexen verfahrenstechnischen Anlagen überlagern sich häufig Sensordaten unterschiedlichster Herkunft. In vielen Fällen enthält der Trainingsdatensatz für ein Machine-Learning-Modell Daten von Sensoren, die für das Verhalten der zu überwachenden Komponente irrelevant sind: Ferner sind die mittels der Sensoren aufgenommenen Werte meist mit Rauschen versehen. Dadurch ist das Training des Algorithmus' oder des Modells erschwert, sodass häufig Muster und Zusammenhänge der Sensordaten schlecht erkannt werden und die Überwachung von Komponenten zu falschen Aussagen führt.

Verbesserungen bei der Zustandsüberwachung mittels maschinellen Lernens können durch die Verwendung extrem großer Datensätze erreicht werden, insbesondere durch die Verbesserung des Trainings. Allerdings sind solch große Datenmengen nicht immer vorhanden und ferner würde das Training mit einem solchen Datensatz sich entsprechend langwierig und kompliziert darstellen. Durch manuelle Selektion von Datensätzen von Sensoren, die für die Überwachung einer Komponente in einer technischen Anlage nicht benötigt werden, kann die Qualität des Trainings (und auch der Auswertung) verbessert werden. Dies ist nachteilig mit einem hohen Arbeitsaufwand verbunden. Dazu kommt häufig das Problem, dass für eine Bestimmung der relevanten Sensor-Datensätze häufig ein domänenspezifisches Wissen über die technische Anlage benötigt wird. Eine auf dem Gebiet der Datenanalyse spezialisierte Person ohne hinreichenden Überblick über den verfahrenstechnischen Prozess in einer technischen Anlage ist in solchen Fällen auf die Zusammenarbeit mit einer Person mit Domänen-Wissen angewiesen, was zusätzlich zu dem großen Arbeitsaufwand einen erheblichen Mehraufwand für mehrere Personen darstellt, und häufig für viele Projekte nicht umsetzbar ist.

Der Erfindung liegt die Aufgabe zugrunde, die Zustandsüberwachung von Komponenten verfahrenstechnischer Anlagen mittels ML Algorithmen zu verbessern und insbesondere den hohen Arbeitsaufwand bei der Auswahl von Trainingsdatensätzen für die verwendeten ML-Algorithmen zu reduzieren.

Diese Aufgabe wird durch die Merkmale des unabhängigen Patentanspruchs 1 gelöst. In den abhängigen Ansprüchen sind vorteilhafte Weiterbildungen der Erfindung, in Anspruch 8 ein Computerprogramm und in Anspruch 9 ein Computerprogrammprodukt beschrieben.

Die Erfindung beruht auf der Erkenntnis, dass die zur Zustandsüberwachung von Komponenten technischer Anlagen eingesetzten ML Algorithmen signifikant bessere Ergebnisse liefern, wenn die Struktur der Anlage, wie sie durch ein Fließschema vorgegeben ist, beim Einlernen der ML Modelle berücksichtigt wird. Voraussetzung dafür ist allein das Vorliegen eines digitalen Fließschemas.

Erfindungsgemäß wird aus dem vorliegenden digitalen Fließschema einer verfahrenstechnischen Anlage, welches die Struktur der technischen Anlage mit ihren Komponenten und deren Funktionen als Zusatzinformationen und deren funktionale Zusammenhänge enthält, ein Graph erzeugt wird, in dem gemäß der aus dem Fließschema vorgegebenen Zusatzinformationen und Zusammenhänge die Komponenten der technischen Anlage als Knoten und die funktionalen Zusammenhänge zwischen den Komponenten als Wirklinien gemäß einer Flussrichtung des Fließschemas enthalten sind. In dem Graphen wird ein Knoten als Zielknoten ausgewählt. Der Zielknoten entspricht einer Komponente, deren Zustand mittels eines ML Algorithmus überwacht werden soll. Gemäß einer auf den Graphen bezogenen Regel und/oder einer Metrik werden anschließend Eingangsknoten des zuvor ausgewählten Zielknotens ermittelt und Sensor-Datensätze der Eingangsknoten, die für die Überwachung der zu überwachenden Komponente relevant sind. Die Datensätze der relevanten Sensoren der Eingangsknoten werden als Eingangsdaten zum Trainieren für den ML Algorithmus des Zielknotens verwendet. Mittels der Ausgangsdaten, den Ergebnissen, des ML Algorithmus wird der Zustand der zu überwachenden Komponente bestimmt.

Der Hauptvorteil der Erfindung liegt darin, dass durch eine gezielte Vorgabe von Eingangsdatensätzen für den ML Algorithmus, die sich allein an der Struktur der Anlage orientiert, die Qualität des Trainings des ML Algorithmus und der Einsatz des ML Algorithmus bei der Zustandsüberwachung von Komponenten technischer Anlagen deutlich verbessert. Ein domänenspezifisches Wissen über die technische Anlage wird dabei nicht benötigt. Durch die Vorgabe einer Regel und/oder Metrik entfällt eine mühsame, manuelle Selektion relevanter Sensor-Datensätze. Das Verfahren kann nach Auswahl der zu überwachenden Komponente, die in der Graphen-Darstellung als Zielknoten repräsentiert wird, überwiegend automatisiert ablaufen, und liefert schnell und zuverlässig die Ausgangsdaten des ML Algorithmus. In der Regel wird es sich bei dem Ergebnis des ML Algorithmus um mindestens eine Prozessvariable handeln, die den Zustand einer Komponente der technischen Anlage charakterisiert.

In einer besonders vorteilhaften Ausführungsvariante kann ein Anwender eine Regel und/oder Metrik selbst bestimmen, also vorgeben oder auswählen. Dies erlaubt eine hohe Flexibilität der Anwendung. Denkbar ist beispielsweise, dass ein Anwender anhand eines Menüs einer graphischen Benutzeroberfläche bestimmte Metriken für die Beziehungen zwischen dem Ziel- und den Eingangsknoten auswählt. Oder dass anhand eines Eingabemenüs die von bestimmten Sensoren erfassten Prozessvariablen der Eingangsknoten eingegeben werden können. Diese Ausführungsvariante erlaubt dem Anwender, das Verfahren zu optimieren, da unterschiedliche Konstellationen von Metriken oder unterschiedliche Regeln eingegeben werden können, um das Berechnungsergebnis des ML Algorithmus zu bewerten.

In weiteren vorteilhaften Ausführungsvarianten des erfindungsgemäßen Verfahrens entsprechen die Datensätze pro Sensor entweder Messwerten der Prozessvariablen oder simulierten Werten der Prozessvariablen. In Echtzeit aufgenommene Datensätze von Messwerten der Prozessvariablen erlauben eine Zustandsüberwachung von Komponenten im laufenden Betrieb der technischen Anlage. Werden simulierte Sensor-Datensätze verwendet ist eine Anwendung des erfindungsgemäßen Verfahrens z.B. vor Inbetriebnahme einer technischen Anlage möglich. Insbesondere könnte ein digitaler Zwilling der technischen Anlage die Datensätze für die Überwachung der Anlage liefern, sodass das Einlernen des ML Algorithmus mittels dieser simulierten Datensätze außerhalb des Betriebs der technischen Anlage erfolgen kann.

In einer weiteren vorteilhaften Ausführungsvariante des erfindungsgemäßen Verfahrens erfolgt das Trainieren des ML Algorithmus im Voraus oder im laufenden Betrieb der technischen Anlage. Ein Extrahieren des Verfahrensschritts des Trainierens, erlaubt eine verbesserte Zustandsüberwachung, da die eigentliche Zustandsbestimmung erst mit einem eintrainierten Algorithmus erfolgt, was zu besseren Berechnungsergebnissen führt.

Dabei ist es besonders vorteilhaft, wenn der Zeitbereich des Trainings einstellbar ist. Ein Anwender kann somit selbst überprüfen, wann der ML Algorithmus die besten Ergebnisse liefert.

Die beschriebenen Weiterbildungen beziehen sich sowohl auf das erfindungsgemäße Verfahren als auch auf die Vorrichtung.

Ferner ist eine Realisierung der Erfindung oder einer beschriebenen Weiterbildung möglich durch ein Computerprogramm, insbesondere einer Software-Applikation, mit durch einen Computer ausführbaren Programmcodeanweisungen zur Implementierung des Verfahrens, wenn das Computerprogramm auf einem Computer ausgeführt wird.

Auch können die Erfindung und/oder jede beschriebene Weiterbildung durch ein Computerprogrammprodukt realisiert sein, welches ein Speichermedium aufweist, auf welchem ein Computerprogramm gespeichert ist, welches die Erfindung und/oder die Weiterbildung ausführt.

Das Computerprogrammprodukt ist vorteilhaft in einen Arbeitsspeicher einer Recheneinheit überführbar und von dort aus mit Hilfe zumindest einer CPU ausführbar. Das Computerprogrammprodukt ist vorteilhaft auf einem Datenspeicher wie einem USB-Stick, einer Festplatte oder einer CD-ROM / DVD-ROM speicherbar und von dort aus auf der Recheneinheit abrufbar oder installierbar.

Im Folgenden wird die Erfindung anhand der in den Figuren dargestellten Ausführungsbeispiele näher beschrieben und erläutert.

Darin zeigen, jeweils in vereinfachter schematischer Darstellung:
- FIG. 1: einen beispielhaften Ausschnitt eines Fließschemas einer verfahrenstechnischen Anlage
- FIG. 2: einen Graphen in Übereinstimmung mit einer ersten beispielhaften Ausführungsform der vorliegenden Erfindung
- FIG. 3: einen Graphen in Übereinstimmung mit einer zweiten beispielhaften Ausführungsform der vorliegenden Erfindung
- FIG. 4: zwei Beispiele für die zeitlichen Verläufe eines aus dem ML Algorithmus resultierenden Schätzwerts einer Prozessvariable einer überwachten Komponente einer Anlage
- FIG. 5: ein Ausführungsbeispiel einer Vorrichtung zur Durchführung des erfindungsgemäßen Verfahrens zur Überwachung eines Zustands einer Komponente einer verfahrenstechnischen Anlage.

Voraussetzung für die vorliegende Erfindung ist das Vorliegen eines Fließschemas in digitalisierter Form. Ein Fließschema ist ein Hilfsmittel in Form einer technischen Zeichnung innerhalb der Verfahrenstechnik. Ein Fließschema einer verfahrenstechnischen Anlage enthält die Struktur der Anlage mit ihren Komponenten und deren Funktionen und funktionalen Zusammenhängen als Zusatzinformation. Eine Ausführungsform eines solchen Fließschemas ist das Rohrleitungs- und Instrumentenfließschema (auch: R&I-Fließschema, engl. P&ID: Piping and Instrumentation Diagram). Es zeigt die Verknüpfung der Leitungen, die Flussrichtungen und sämtliche Einbauten einer Rohrleitung. Digitalisierte Fließschemata können mittels Anlagenplanungstools wie beispielsweise COMOS der Siemens AG erzeugt werden.

Soweit in der vorliegenden Anmeldung von technischen Anlagen und Fließbildern die Rede ist, sind darunter auch einzelne selbständige oder miteinander verbundene (oder zu verbindende) Teil-Anlagen oder Teil-Fließbilder zu verstehen.

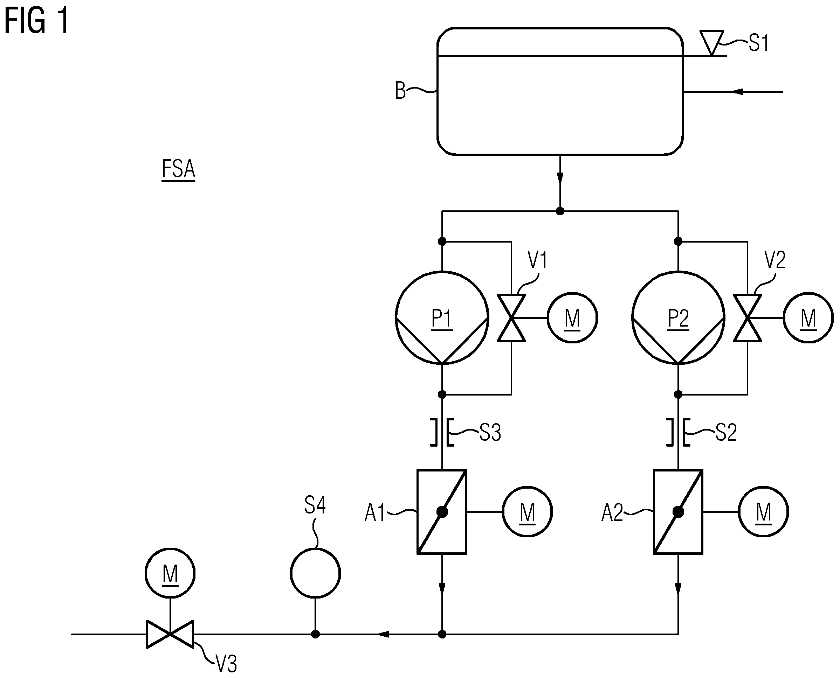

FIG. 1 zeigt einen beispielhaften Ausschnitt aus einem Rohrleitungs- und Instrumentenfließschema einer verfahrenstechnischen Anlage. Der Ausschnitt FSA enthält grafische Prozessobjekte, die die unterschiedlichen Komponenten der Anlage, wie Pumpen, Behälter, Absperrklappen oder Ventile repräsentieren und entsprechend der Verrohrung der Anlage miteinander verknüpft sind. Die Prozessobjekte enthalten üblicherweise auch technische Informationen über die Parameter der von ihnen repräsentierten Komponenten, wie z. B. Rohrleitungsdurchmesser oder Füllvolumen eines Behälters (hier nicht dargestellt). Der hier gezeigte Fließschemaausschnitt FSA zeigt einen Behälter B an dem mittels eines Sensors S1 der Füllstand gemessen wird. Durch Wirklinien mit Pfeilen sind Zu- und Ablauf des Behälters B erkennbar. Der Ablauf des Behälters zweigt sich in zwei Stränge auf. In den entsprechenden Rohrleitungsabschnitten finden sich Pumpen P1 und P2 mit zugehörigen Ventilen V1 und V2 und Sensoren S3 und S2 zur Messung des Durchflusses am Pumpenausgang. In Flussrichtung sind hinter den Pumpen P1 und P2 Absperrklappen A1 und A2 angeordnet. Weiter in Flussrichtung des gemeinsamen Abflussrohres sind ein Drucksensor S4 und ein weiteres Ventil V3 angeordnet. Neben der Sensorik, die hier durch die Sensoren S1, S2, S3 und S4 repräsentiert ist, ist auch die Aktorik (repräsentiert durch Motoren M zum Antrieb von Teilen der Komponenten) der Anlage mit den entsprechenden technischen Informationen (hier nicht dargestellt) dem Fließschema zu entnehmen. Mittels der Sensoren werden Prozessvariablen wie Druck, Temperatur, Füllstand oder Durchfluss gemessen. Pro Sensor werden entsprechende Datensätze, welche z.B. aus Zeitreihendaten der gemessenen Prozessvariablen bestehen können, aufgenommen und in einem Zwischenspeicher oder einer Datenbank abgespeichert.

Aus dem Ausschnitt FSA geht klar hervor, dass der Zustand einer Komponente (z.B. des Behälters B, der Pumpen P1 und P2 oder der Absperrklappen A1 und A2) anhand einer Anzahl von Sensoren bestimmt werden kann. Die Komponente der Pumpe P1 steht in direktem Wirkzusammenhang mit den Sensoren S1, S3 und S4. Die Wirklinien oder Wirkzusammenhänge können in eine Richtung beschränkt sein oder bidirektional sein, also in zwei Richtungen wirken. Diese Wirkzusammenhänge können nun in einer GraphenDarstellung vereinfacht festgehalten werden.

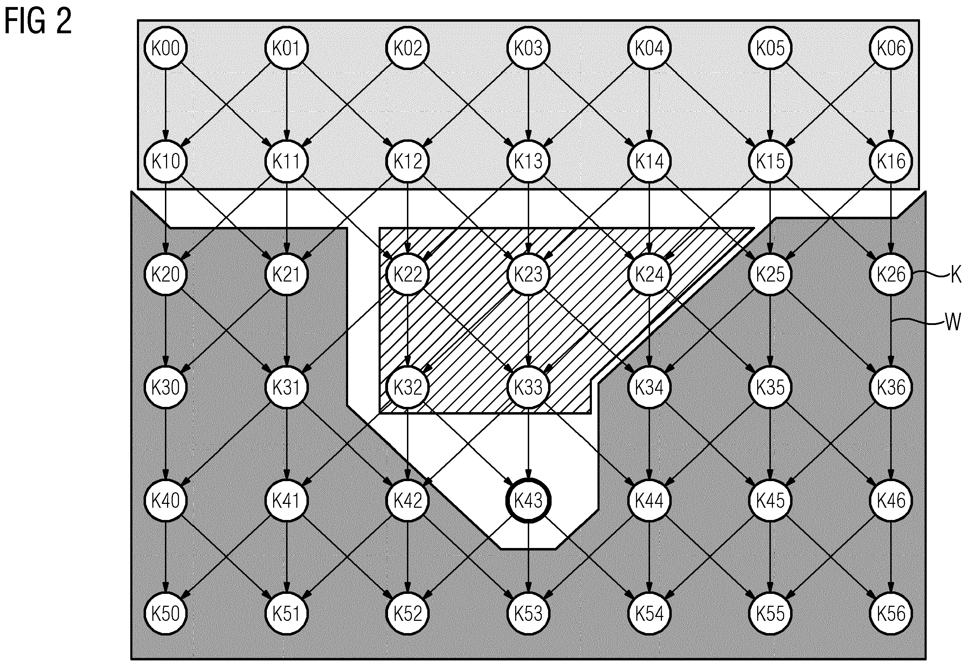

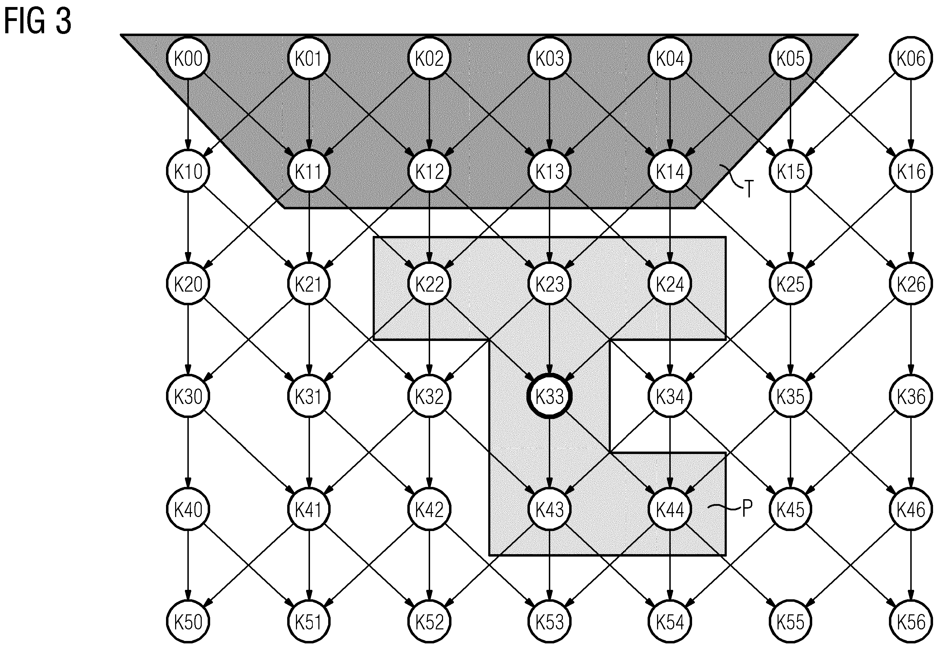

Eine Ausführungsform einer Graphen-Darstellung ist in den Figuren 2 und 3 gezeigt. Ein Graph im Sinne der Erfindung umfasst jede schematische Darstellung, in der gemäß der aus dem Fließschema vorgegebenen Zusatzinformationen und Zusammenhänge die Komponenten der technischen Anlage als Knoten K und die funktionalen Zusammenhänge zwischen den Komponenten als Wirklinien W mit einer Richtungsangabe gemäß der Flussrichtung des Fließschemas oder auch zumindest teilweise bidirektional enthalten sind. Wirklinien gemäß einer Flussrichtung des Fließschemas können demnach eine Richtung besitzen (für den Fluss eines Mediums durch ein Rohr in eine Richtung) oder bidirektional (im Falle eines Druckausgleichsrohres) sein. Dabei kann es sich zum Beispiel um einen Knowledge-Graphen handeln. Die Erfindung ist jedoch nicht auf einen Knowledge-Graphen beschränkt. Verschiedene Arten von Graphen oder Ontologien können verwendet werden, solange die Art der Objekte und die Verbindung zwischen zwei beliebigen Objekten abgefragt werden kann.

Graphen zur Darstellung von Wirkzusammenhängen zwischen Objekten oder Komponenten technischer Anlagen sind vielfach aus dem Stand der Technik bekannt:
Aus der US 2022/0075515 Al ist bekannt, eine interaktive grafische Benutzeroberfläche mit mehreren Modi und Panels zu generieren, die den Benutzern ermöglichen, Modelle zu visualisieren und zu analysieren. Ein Nutzer kann dabei ein Objekt des graphischen Modells auswählen und erhält alle verknüpften Objekte mit weiteren Informationen. Diese Informationen können zu Simulationen der Modelle verwendet werden.

Die WO 2022/035427 A1 beschreibt ein Verfahren für die Unterstützung eines Ingenieurs bei der Erzeugung eines CAD-Designs eines technischen Prozesses. Dabei wird ein KI-Modul in das Ingenieurwerkzeug integriert, um die Funktionalität von Komponenten für das aktuelle Designprojekt mithilfe eines trainierten maschinenlernbasierten Modells zu klassifizieren. Das KI-Modul erhält einen Wissensgraphen für das aktuelle Projekt, der auf Daten basiert, die mit dem grafischen Design des technischen Prozesses verknüpft sind. Der Wissensgraph repräsentiert eine Ontologie für eine Reihe von Elementen und Elementbeziehungen, die Systemkomponenten darstellen. Das KI-Modul identifiziert die Funktionalität für jeden Knoten im Wissensgraphen basierend auf dem Klassifikationsmodell, gruppiert die Knoten des Wissensgraphen entsprechend der identifizierten Funktionalität und generiert funktionalitätsbasierte Empfehlungen basierend auf den Gruppen als Reaktion auf Benutzeranfragen.

Die WO 2020/198249 A1 beschreibt Systeme und Methoden zur Steuerung einer Industrieanlage umfassend das Eingeben eines Engineering-Diagramms für eine Einheit der Industrieanlage, wobei das Engineering-Diagramm Symbole enthält, die Assets der Industrieanlage darstellen; das Extrahieren eines oder mehrerer Assets aus dem Engineering-Diagramm mithilfe von maschinellem Lernen, um ein oder mehrere Assets zu erkennen, wobei die ein oder mehreren Assets Ausrüstung, Instrumente, Verbindungen und Leitungen umfassen, wobei die Leitungen die Ausrüstung, Instrumente und Verbindungen miteinander verbinden; das Bestimmen einer oder mehrerer Beziehungen zwischen der Ausrüstung, Instrumenten, Verbindungen und Leitungen mithilfe von maschinellem Lernen, um eine oder mehrere Beziehungen zu erkennen; und das Erstellen eines Flussdiagramms aus den Assets sowie deren Beziehungen untereinander.

In einem Ausführungsbeispiel unterstützt das Anlagenplanungswerkzeug den Export des digitalen R&I-Schemas im sog. DEXPI-Format. Die Abkürzung DEXPI steht für "Data Exchange in the Process Industry" (dt. Datenaustausch in der Prozessindustrie). Das DEXPI-Format entspricht einem neutralen Datenformat, mit dessen Hilfe neutrale Prozessinformationen zwischen Softwareprodukten verschiedener Hersteller von Ingenieurswerkzeugen ausgetauscht werden können. Ein digitales Fließschema im DEXPI-Format kann selbst als Graph verwendet werden oder in ein anderes Format umgewandelt werden kann. Darin sind alle Geräte und Sensoren sowie die Verbindungen dazwischen mit Richtung in vereinfachter graphischer Darstellung enthalten. Die Basis für die Graphen stellt eine gemeinsames Datenmodell dar. Bei der Übertragung eines P&IDs in ein Graphen erfolgt ein Datentransfer, der Grafiken, Symbole, Topologie, alle technischen Attribute, Aufzählungen, Auswahllisten usw. enthalten sollte, um eine nahtlose Fortsetzung der Funktionen des P&IDs im Zielsystem zu ermöglichen.

Liegt ein digitales R&I-Schema, z.B. in Form eines Knowledge Graphen oder einer ähnlichen Ontologie vor, kann anschließend ermittelt werden, welche Sensoren im jeweiligen Anwendungsfall einen relevanten Bezug zu einem zu überwachenden Gerät oder einer zu überwachenden Komponente einer verfahrenstechnischen Anlage besitzen und somit für das Trainieren eines ML Algorithmus besonders relevant sind.

Soll demnach der Zustand eines bestimmten Geräts oder einer Komponente einer verfahrenstechnischen Anlage mittels eines ML Algorithmus überwacht werden, wählt beispielsweise ein Anwender des erfindungsgemäßen Verfahrens, welches in einer Ausführung als Computerprogrammprodukt implementiert sein kann, in einem Schritt einen Knoten der Graphen-Darstellung als Zielknoten aus. Der Zielknoten innerhalb der Graphen-Darstellung entspricht einer Komponente, deren Zustand überwacht werden soll. Die Auswahl des Zielknotens kann alternativ automatisch erfolgen und/oder von einer Software vorgegeben werden. Für den Zielknoten soll ein ML Algorithmus trainiert werden.

Im nächsten Schritt sollen die Sensor-Datensätze bestimmt werden, welche mit der Komponente des Zielknotens in einem Wirkzusammenhang stehen und somit den Zustand der zu überwachenden Komponente des Zielknotens bestimmen. Die Komponenten und Sensoren, die für die Überwachung der zu überwachenden Komponente des Zielknotens relevant sind, werden in der Graphen-Darstellung als Eingangsknoten bezeichnet. Dabei kann es sich sowohl um in Fließrichtung dem Zielknoten vorgeschaltete Knoten, als auch um in Fließrichtung dem Zielknoten nachgeschaltete Knoten handeln. Welche Eingangsknoten (Komponenten) relevant für die Zustandsbestimmung der Komponente des Zielknotens ist ergibt sich aus dem jeweiligen Anwendungsfall. Gemäß der Erfindung ist es auch möglich, bestimmte Eingangsknoten gemäß einer Metrik oder einer Regel vorzugeben.

Unter einer Metrik wird im Sinne dieser Erfindung eine Abstandsfunktion oder ein beliebiges Abstandsmaß verstanden, wie es in der Mathematik zwischen zwei Punkten eines Raumes definiert ist. Dabei kann es sich z.B. um die Länge des kürzesten Pfades, Resistance Distance oder euklidische Abstände handeln. Grundsätzlich soll durch eine Metrik bestimmt werden, wie "nahe" die (Wirk-)Verbindung zwischen Sensor und zu überwachendem Gerät sein muss, damit der Sensor als relevant gilt. Im einfachsten Fall könnten die nächsten Nachbarknoten mit deren Sensor-Datensätzen als Eingangsknoten ausgewählt werden. Häufig werden sich aus dem Anwendungsfall jedoch kompliziertere Fälle ergeben. Wenn beispielsweise die Temperatur bestimmt werden soll, die in 5 Minuten an einer Komponente des Zielknotens herrschen wird, und die in den zuführenden Rohrleitungen transportierte Flüssigkeit etwa 1 +- 0.3 Minuten braucht, um die jeweils nächste Komponente zu erreichen, dann wäre es sinnvoll, nur die flussaufwärts liegenden Knoten im Abstand zwischen 4 und 6 Knoten vom Zielknoten als Eingangsknoten zu wählen. In diesem Fall würde die Auswahl der Eingangsknoten demzufolge nach einer Regel erfolgen. Ein anderes Beispiel für eine Regel wäre, alle Drucksensoren im Abstand von maximal einem Knoten flussabwärts als Eingangsknoten auszuwählen sowie alle flussaufwärts liegenden Temperatursensoren der Knoten im Abstand von 2 bis 3 Knoten vom Zielknoten.

In einer besonders vorteilhaften Ausführungsvariante der Erfindung können die Regeln und Metriken, welche Knoten der Graphen-Darstellung für den entsprechenden Anwendungsfall als relevante Eingangsknoten definiert werden sollen, von einem Anwender (einem Datenanalysten oder einem Domain Experten) vorgegeben werden. Die Regeln und Metriken, welche Knoten für das spezifische Problem als relevant gelten, kann beispielsweise einmalig aufgestellt werden und kann in der Folge auf alle hinreichend ähnlichen Geräte/Zielknoten (z.B. auf alle ähnlichen Pumpen der Anlage) angewandt werden. So können ohne erheblich Mehrwaufwand alle hinreichend ähnlichen Geräte/Zielknoten und somit die gesamte Anlage in dieser Hinsicht während des laufenden Betriebs überwacht werden.

Da jeder Knoten der Graphen-Darstellung eine Komponente der verfahrenstechnischen Anlage repräsentiert, die mit verschiedenen Sensoren verbunden ist (vgl. auch Fig. 1), ergeben sich aus der Bestimmung der Eingangsknoten entsprechend die für die Zustandsbestimmung der Komponente des Zielknotens relevanten Sensor-Datensätze, die als Eingangsdaten zum Trainieren für den ML Algorithmus des Zielknotens verwendet werden, wobei mittels der Ausgangsdaten des ML Algorithmus der Zustand des Zielknotens bestimmt wird.

In Fig. 2 ist ein erstes Ausführungsbeispiel zur Veranschaulichung des erfindungsgemäßen Verfahrens angegeben. In der Graphen-Darstellung in Fig. 2, welche auf einem R&I Fließschema einer verfahrenstechnischen Anlage basiert, werden bestimmte für den Betrieb der verfahrenstechnischen Anlage erforderlichen Komponenten als Knoten K und die zwischen den Komponenten verlaufenden Rohrleitungen als Wirklinien repräsentiert. In dem stark vereinfachten Ausschnitt des als Graphen dargestellten R&I-Fließschemas verläuft die Fließrichtung entlang der Pfeilrichtungen, generell von oben nach unten mit diagonalen Verbindungen zu den nächsten Nachbarn, wobei einige Verbindungen fehlen. In diesem Fall stellen die Komponenten der Knoten Temperaturmesspunkte innerhalb eines Rohrleitungssystems dar. Die Knotenpunkte entsprechen demnach einem Rohrabschnitt, an denen die Temperatur der beförderten Flüssigkeit mit einem Sensor (Temperatursensor) gemessen wird. Die Pfeile zwischen den Knoten deuten die Flussrichtung der Flüssigkeit zwischen Rohrabschnitten mit den Sensoren an. Komponente und Sensor sind demnach in diesem Ausführungsbeispiel als gleich anzusehen. Im Allgemeinen ist jede Komponente eines Knotens der Graphen-Darstellung mit mehr als einem Sensor verbunden.

In diesem Ausführungsbeispiel soll nun für den Zielknoten K43 ein ML Algorithmus trainiert werden, welcher den Zustand der Rohrleitung an diesem Messpunkt überwachen soll, indem die Temperatur in diesem Rohrabschnitt mittels des ML Algorithmus geschätzt wird. Der Messpunkt innerhalb des Rohrleitungsschemas wird durch den Zielknoten K43 repräsentiert. Für die Zustandsbestimmung des Rohrabschnitts am Zielknoten sind aufgrund der Gegebenheiten dieses Anwendungsfalls allein die Datensätze der flussaufwärts liegenden Temperatursensoren relevant, da nur diese Information über die Flüssigkeit enthalten, die in den Rohrabschnitt strömt, der durch den Zielknoten repräsentiert wird. Des Weiteren können weit entfernt flussaufwärts liegende Temperatursensoren ignoriert werden, da sich ihre Information in den Datensätzen der späteren Sensoren widerspiegelt und sich stark mit der Information irrelevanter Sensoren vermischt bevor der Zielsensor erreicht ist. In diesem Beispiel ist daher ein Maximalabstand von zwei Knoten zwischen dem Zielknoten und den als relevant ermittelten Eingangsknoten gewählt. Die Metrik ist hier also die Länge des kürzesten Pfades. In Fig. 2 sind in der dunkelgrau schraffierten Fläche die Eingangsknoten K32, K22, K33, K23 und K24 des Zielknotens K43 zu erkennen. Nur die Datensätze der Sensoren der Eingangsknoten K32, K22, K33, K23 und K24 werden somit für das Trainieren des ML Algorithmus des Zielknotens verwendet. Die Datensätze der weiter entfernten Sensoren der Knoten K00 bis K16 der hellgrau hinterlegten Fläche brauchen nicht beim Trainieren des ML Algorithmus verwendet werden und sind für den Zustand des Rohrabschnitts, der durch den Zielknoten repräsentiert wird, vernachlässigbar. Die Datensätze, welche im Zusammenhang mit den Knoten stehen, welche flussabwärts hinter dem Zielknoten angeordnet sind, sind für die Zustandsbestimmung des Zielknotens irrelevant.

In Fig. 3 ist ein zweites Ausführungsbeispiel zur Veranschaulichung des erfindungsgemäßen Verfahrens angegeben. In dieser Graphen-Darstellung repräsentieren die Knoten Rohrabschnitte innerhalb eines Rohrleitungssystems, an denen sowohl die Temperatur der beförderten Flüssigkeit mit einem Sensor (Temperatursensor), als auch der Druck innerhalb des Rohrabschnitts mit einem weiteren Sensor gemessen wird. Die Pfeile zwischen den Knoten deuten auch hier die Flussrichtung der Flüssigkeit zwischen den Rohrabschnitten mit den Sensoren an. In diesem Ausführungsbeispiel ist demnach jede Komponente (=Rohrabschnitt) mit zwei Sensoren (hier Temperatur- und Drucksensor) verbunden.

In diesem Ausführungsbeispiel wird als Zielknoten der Knoten K33 ausgewählt, für den ein ML Algorithmus trainiert werden soll, welcher den Zustand der Rohrleitung in diesem Rohrabschnitt überwachen soll. Die Eingangsknoten werden hier gemäß einer Regel ausgewählt. Es sollen für den ML Algorithmus nur die Datensätze der Drucksensoren der benachbarten Knoten (also der Knoten mit Abstand von maximal einem Knoten vom Zielknoten entfernt) berücksichtigt werden und die Datensätze der Temperatursensoren der flussaufwärts liegenden Knoten im Abstand von 2 bis 3 Knoten. Somit werden die Knoten K22, K23, K24, K43 und K44 als Eingangsknoten bestimmt, wobei nur die Datensätze der Drucksensoren dieser Knoten relevant für die Zustandsbestimmung des Rohrabschnitts des Zielknotens K33 sind. In der Graphen-Darstellung in Fig. 3 handelt sich um die Knoten im hellgrau hinterlegten Feld P. Zusätzlich werden auch die Knoten in dem dunkelgrau hinterlegten Feld T als Eingangsknoten bestimmt, wobei nur die Datensätze der Temperatursensoren berücksichtigt werden.

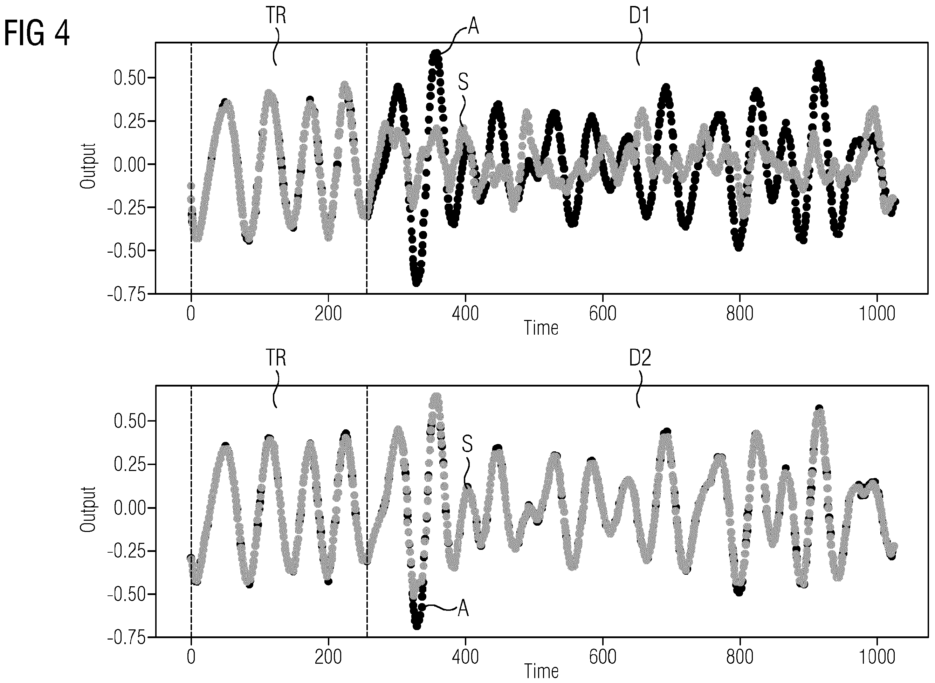

Die Auswahl nur bestimmter, relevanter Datensätze als Eingangsdatensätze für einen ML Algorithmus gemäß dem erfindungsgemäßen Verfahren trägt zu einer deutlichen Verbesserung der mittels des Algorithmus berechneten Ausgangsgröße bei. Dies soll anhand der beiden Diagramme in Fig. 4 verdeutlicht werden. Beide Diagramme zeigen die zeitlichen Verläufe der Ausgangsgröße des ML Algorithmus für den Prozesswert der Komponente des Zielknotens K43 aus Ausführungsbeispiel 1 (vgl. Fig. 2). Der Knoten K43 aus Fig. 2 repräsentiert einen Temperatursensor in einem Rohrabschnitt eines Rohrleitungssystems. Mittels des ML Algorithmus kann der Temperaturmesswert basierend auf den Eingangsdatensätzen, m.a.W. den Datensätzen der Eingangsknoten, geschätzt werden. In beiden Diagrammen D1 und D2 ist die Ausgangsgröße A des verwendeten ML Algorithmus gegen die Zeit aufgetragen. Zusätzlich ist der Ziel- oder Sollwert der Ausgangsgröße S gegen die Zeit aufgetragen. In beiden Diagrammen ist ferner die Zeitspanne TR markiert, die für das Trainieren des Algorithmus aufgewendet wurde.

In Diagramm D1 ist zu erkennen, dass während der Trainingsphase TR die beiden Verläufe der Ausgangsgröße, d.h. die Sollwerte und die mittels des ML Algorithmus berechneten Temperaturwerte noch annähernd übereinstimmen. In der Auswertungsphase hingegen treten in D1 signifikante Abweichungen auf. Dies ist darin begründet, dass die Trainingsdatensätze für den ML Algorithmus in Diagramm D1 auch irrelevante Eingangsdatensätze enthalten, während in Diagramm D2 nur gemäß der Erfindung relevante Trainingsdatensätze für die Berechnung der geschätzten temperaturwerte verwendet wurden. In Diagramm D1 wurde der ML Algorithmus mittels der Datensätze aller Knoten (60 Temperatursensoren) der in Fig. 2 gezeigten Graphen-Darstellung eintrainiert. In Diagramm D2 wurde der ML Algorithmus nur mit den relevanten Datensätzen der Knoten K22, K23, K24, K32 und K33 der in Fig. 2 gezeigten Graphen-Darstellung eintrainiert. Auf diese Weise kann eine deutliche Verbesserung der Zustandsüberwachung des betrachteten Rohrabschnitts erreicht werden.

Die Erfindung und die beschriebenen Weiterbildungen wird bevorzugt in Software als auch in Hardware, beispielsweise unter Verwendung einer speziellen elektrischen Schaltung realisiert oder in einer Kombination aus Soft- und Hardware implementiert wie beispielsweise einer Vorrichtung zur Datenverarbeitung.

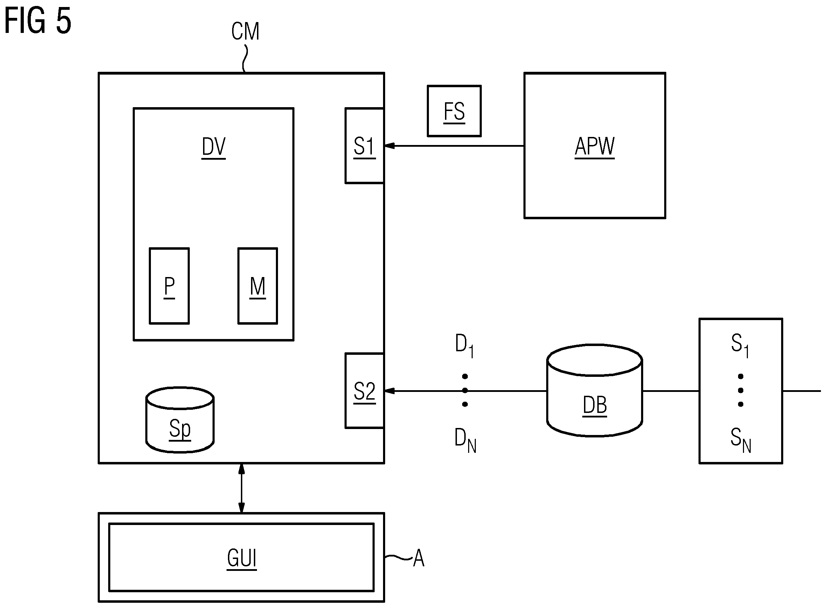

In Fig. 5 ist ein Ausführungsbeispiel einer Vorrichtung CM zur Überwachung eines Zustands einer Komponente einer verfahrenstechnischen Anlage dargestellt. Die Vorrichtung CM weist in dieser Ausführung mindestens eine Schnittstelle S1 zum Empfang eines digitalen Fließschemas FS der technischen Anlage auf. Ein solches, ggf. aus mehreren Teilbildern bestehendes Fließ- oder Rohrleitungsschema (R&I-Schema) wird üblicherweise mittels eines Anlagenplanungswerkzeugs APW in bekannter Weise z.B. durch einen Anlagenplaner oder Technologen durch Verknüpfung von die Komponenten der technischen Anlage repräsentierenden grafischen Prozessobjekten erstellt. Die Vorrichtung CM weist ferner mindestens eine weitere Schnittstelle S2 zum Empfang von Datensätzen D1 bis DN (N = natürliche Zahl) oder daraus abgeleiteter Größen von Sensoren S1 bis SN, welche mit mindestens einer Komponente der verfahrenstechnischen Anlage verbunden sind. Die von den Sensoren erfassten Datensätze mit Prozessvariablen können in einer Datenbank DB zwischengespeichert werden. Die Vorrichtung CM kann alternativ auch eine einzige Schnittstelle aufweisen, welche dazu ausgebildet ist, beliebige Daten und/oder Dateien zu empfangen.

Die Vorrichtung CM weist ferner mindestens eine Datenverarbeitungseinrichtung DV auf, welche basierend auf dem übermittelten digitalen Fließschema und den übermittelten Sensor-Datensätzen das erfindungsgemäße Verfahren ausführt. Die Vorrichtung CM kann ferner ein Archiv oder sonstige beliebige Speichereinheit SP oder Datenbank umfassen, in welcher beispielsweise die Fließschemata oder Graphen abgelegt sind. Die Datenverarbeitungseinrichtung DV weist mindestens einen Prozessor P oder CPU und einem Arbeitsspeicher M auf. Die als Computerprogramm implementierte Erfindung kann beispielsweise im Arbeitsspeicher M vorgehalten werden oder in diesen geladen werden, und von dort aus mit Hilfe des zumindest einen Prozessors P ausgeführt werden.

Die Vorrichtung kann ferner eine Anzeigeeinheit A aufweisen oder mit einer solchen verbunden sein, die dazu ausgebildet ist, dass auf einer Benutzeroberfläche GUI eine Komponente der technischen Anlage überwacht werden kann. Über die Graphische Benutzeroberfläche kann ein Anwender beliebig mit der Datenverarbeitungseinrichtung DV der Vorrichtung CM interagieren.

## Patentansprüche

1. Verfahren zur Überwachung eines Zustands einer Komponente einer verfahrenstechnischen Anlage,
die eine Vielzahl von miteinander verfahrenstechnisch verbundenen Komponenten aufweist,
- wobei der Zustand einer Komponente anhand von Prozessvariablen von mindestens einem für die Komponente relevanten Sensor bestimmt und pro Sensor entsprechende Datensätze aufgenommen und abgespeichert werden,
- wobei aus einem digitalen Fließschema der technischen Anlage, welches die Struktur der technischen Anlage mit ihren Komponenten und deren Funktionen als Zusatzinformationen und deren funktionale Zusammenhänge enthält, ein Graph erzeugt wird, in dem gemäß der aus dem Fließschema vorgegebenen Zusatzinformationen und Zusammenhänge die Komponenten der technischen Anlage als Knoten und die funktionalen Zusammenhänge zwischen den Komponenten als Wirklinien gemäß einer Flussrichtung des Fließschemas enthalten sind,
**dadurch gekennzeichnet,**
- **dass** ein Knoten des Graphen als Zielknoten ausgewählt wird, der einer Komponente entspricht, deren Zustand mittels eines ML Algorithmus überwacht werden soll,
- **dass** gemäß einer auf den Graphen bezogenen Regel und/oder einer Metrik Eingangsknoten und Sensor-Datensätze der Eingangsknoten, die für die Überwachung der zu überwachenden Komponente relevant sind, des zuvor ausgewählten Zielknotens ermittelt werden
- **dass** die Datensätze der relevanten Sensoren der Eingangsknoten als Eingangsdaten zum Trainieren für den ML Algorithmus des Zielknotens ausgewählt werden, und
- **dass** mittels der Ausgangsdaten des ML Algorithmus der Zustand der zu überwachenden Komponente bestimmt wird.

2. Verfahren nach Anspruch 1,
**dadurch gekennzeichnet,**
**dass** die Regel und/oder Metrik von einem Anwender vorgegeben oder ausgewählt werden.

3. Verfahren nach einem der vorhergehenden Ansprüche,
**dadurch gekennzeichnet,**
**dass** die Datensätze pro Sensor Messwerten der Prozessvariablen oder simulierten Werten der Prozessvariablen entsprechen.

4. Verfahren nach einem der vorhergehenden Ansprüche,
**dadurch gekennzeichnet,**
**dass** das Trainieren des ML Algorithmus im Voraus oder im laufenden Betrieb der technischen Anlage erfolgt.

5. Verfahren nach einem der vorhergehenden Ansprüche, **dadurch gekennzeichnet,**
**dass** ein Zeitbereich des Trainings einstellbar ist.

6. Vorrichtung (CM) zur Überwachung eines Zustands einer Komponente einer verfahrenstechnischen Anlage, die eine Vielzahl von miteinander verfahrenstechnisch verbundenen Komponenten aufweist, wobei jede Komponente mit einer Anzahl von Sensoren (S1, ...SN) zur Erfassung von Datensätzen (D1, ...DN) von Prozessvariablen verbunden ist,
- mit einer Schnittstelle (S1) zum Empfang eines digitalen Fließschemas (FS) der technischen Anlage,
- mit einer weiteren Schnittstelle (S2) zum Empfang der Datensätze (D1, ...DN) oder daraus abgeleiteter Größen der Sensoren (S1, ...SN) der Komponenten der technischen Anlage, und
- mit einer Datenverarbeitungseinrichtung (DV), die dazu ausgebildet ist, das Verfahren nach einem der Ansprüche 1 bis 5 durchzuführen.

7. Vorrichtung (CM) nach Anspruch 6, ferner aufweisend eine Anzeigeeinheit (A), die dazu ausgebildet ist, dass mittels einer Benutzeroberfläche (GUI) zumindest eine Auswahl eines Zielknotens erfolgt, der im Zusammenhang mit der Komponente steht, die überwacht werden soll, und dass beliebige Interaktionen eines Anwenders mit der Datenverarbeitungseinrichtung (DV) durchführbar sind.

8. Computerprogramm, insbesondere Software-Applikation, mit durch einen Computer ausführbaren Programmcodeanweisungen zur Implementierung des Verfahrens nach einem der Ansprüche 1 bis 5, wenn das Computerprogramm auf einem Computer ausgeführt wird.

9. Computerprogrammprodukt, insbesondere Datenträger oder Speichermedium, mit einem durch einen Computer ausführbaren Computerprogramm gemäß Anspruch 8.

## Claims

1. Method for monitoring a condition of a component of a process engineering plant,
which has a large number of components that are connected to one another from a process engineering perspective,
- wherein the condition of a component is determined on the basis of process variables of at least one sensor relevant for the component and corresponding data sets are recorded and stored for each sensor,
- wherein from a digital flow diagram of the technical plant, which contains the structure of the technical plant with its components and the functions thereof as additional information and the functional relationships thereof, a graphic is generated which, according to the additional information and relationships specified from the flow diagram, contains the components of the technical plant as nodes and the functional relationships between the components as working lines, according to a flow direction of the flow diagram,
**characterised in that**
- a node of the graphic is selected as target node, which corresponds to a component, the condition of which is to be monitored by means of an ML algorithm,
- according to a rule and/or a metric related to the graphic, input nodes and sensor data sets of the input nodes, which are relevant for the monitoring of the component to be monitored, of the target node selected in advance are ascertained,
- the data sets of the relevant sensors of the input nodes are selected as input data for the training for the ML algorithm of the target node, and
- by means of the output data of the ML algorithm, the condition of the component to be monitored is determined.

2. Method according to claim 1,
**characterised in that**
the rule and/or metric is specified or selected by an operator.

3. Method according to one of the preceding claims,
**characterised in that**
the data sets for each sensor correspond to measurement values of the process variables or simulated values of the process variables.

4. Method according to one of the preceding claims,
**characterised in that**
the training of the ML algorithm takes place in advance or during ongoing operation of the technical plant.

5. Method according to one of the preceding claims,
**characterised in that**
it is possible to set a time range of the training.

6. Apparatus (CM) for monitoring a condition of a component of a process engineering plant, which has a large number of components that are connected to one another from a process engineering perspective, wherein each component is connected to a number of sensors (S1, ...SN) for the detection of data sets (D1, ...DN) of process variables,
- with an interface (S1) for receiving a digital flow diagram (FS) of the technical plant,
- with a further interface (S2) for receiving the data sets (D1, ...DN) or variables derived therefrom of the sensors (S1, ...SN) of the components of the technical plant, and
- with a data processing facility (DV), which is embodied to perform the method according to one of claims 1 to 5.

7. Apparatus (CM) according to claim 6,
further having a display unit (A), which is embodied such that by means of a user interface (GUI) at least one selection of a target node takes place, which is related to the component that is to be monitored, and such that any given interactions of an operator with the data processing facility (DV) can be performed.

8. Computer program, in particular software application, with program code instructions that can be carried out by a computer in order to implement the method according to one of claims 1 to 5, when the computer program is executed on a computer.

9. Computer program product, in particular data carrier or storage medium, with a computer program according to claim 8 that can be executed by a computer.

## Revendications

1. Procédé de contrôle de l'état d'un composant d'une installation de la technique des procédés,
qui a une pluralité de composants reliés les uns aux autres en technique des procédés,
- dans lequel on détermine l'état d'un composant à l'aide de variables de processus par au moins un capteur pertinent pour le composant et on enregistre, par capteur, des ensembles de données correspondants et on les met en mémoire,
- dans lequel, à partir d'un schéma de circulation numérique de l'installation technique, qui contient la structure de l'installation technique avec ses composants et leurs fonctions, comme informations supplémentaires, et leurs relations fonctionnelles, on produit un graphe, dans lequel, conformément aux informations supplémentaires données à l'avance, à partir du schéma de circulation et des relations, les composants de l'installation technique sont contenus sous la forme de nœuds et les relations fonctionnelles entre les composants, sous la forme de lignes d'action suivant une direction de flux du schéma de circulation,
**caractérisé**
- **en ce que** l'on choisit un nœud du graphe, comme nœud cible, qui correspond à un composant, dont l'état doit être contrôlé au moyen d'un algorithme LM,
- **en ce que**, conformément à une règle tirée du graphe et/ou à une métrique, on détermine des nœuds d'entrée et des ensembles de données de capteur des nœuds d'entrée, qui sont pertinents pour le contrôle du composant à contrôler du nœud cible choisi auparavant,
- **en ce que** l'on choisit les ensembles de données des capteurs pertinents des nœuds d'entrée, comme données d'entrée, pour entraîner l'algorithme LM du nœud cible,
- **en ce que**, au moyen des données de sortie de l'algorithme LM, on détermine l'état du composant à contrôler.

2. Procédé suivant la revendication 1,
**caractérisé**
**en ce que** la règle et/ou la métrique est donnée à l'avance ou choisie par un utilisateur.

3. Procédé suivant l'une des revendications précédentes,
**caractérisé**
**en ce que** les ensembles de données correspondent, par capteur, à des valeurs de mesure des variables de processus ou à des valeurs simulées des variables de processus.

4. Procédé suivant l'une des revendications précédentes,
**caractérisé**
**en ce que** l'entraînement de l'algorithme LM s'effectue à l'avance ou au cours du fonctionnement de l'installation technique.

5. Procédé suivant l'une des revendications précédentes,
**caractérisé**
**en ce que** le laps de temps de l'entraînement est réglable.

6. Système (CM) de contrôle de l'état d'un composant d'une installation de la technique des procédés, qui a une pluralité de composants reliés entre eux en technique des procédés, dans lequel chaque composant est relié à un nombre de capteurs (S1, ...SN) de détection d'ensembles (D1, ...DN) de données de variables de processus,
- comprenant une interface (S1) de réception d'un schéma (FS) de circulation numérique de l'installation,
- comprenant une autre interface (S2) de réception des ensembles (D1, ...DN) de données ou de grandeurs, qui s'en déduisent, des capteurs (S1, ...SN) des composants de l'installation technique, et
- comprenant un dispositif (DV) de traitement de données, qui est constitué pour exécuter le procédé suivant l'une des revendications 1 à 5.

7. Système (CM) suivant la revendication 6,
comportant en outre une unité (A) d'affichage, qui est constituée pour, au moyen d'une surface (GUI) d'utilisateur, effectuer au moins le choix d'un nœud cible, qui est en relation avec le composant à contrôler, et en ce que des interactions d'un utilisateur avec le dispositif (DV) de traitement de données peuvent être effectuées.

8. Programme d'ordinateur, en particulier application logicielle, comprenant des instructions de code de programme pouvant être exécutées par un ordinateur pour la mise en œuvre du procédé suivant l'une des revendications 1 à 5, lorsque le programme est exécuté sur un ordinateur.

9. Produit de programme d'ordinateur, en particulier support de données ou support de mémoire, comprenant un programme d'ordinateur suivant la revendication 8, pouvant être exécuté par un ordinateur.
